(19) Europäisches Patentamt

European Patent Office

Office européen des brevets

(11) **EP 1 260 018 B1**

(12) **EUROPEAN PATENT SPECIFICATION**

(45) Date of publication and mention
of the grant of the patent:
**18.10.2006 Bulletin 2006/42**

(51) Int Cl.:
*H03F 3/50* (2006.01)          *H03K 19/086* (2006.01)
*H03F 3/45* (2006.01)

(21) Application number: **00987550.1**

(22) Date of filing: **21.12.2000**

(86) International application number:
**PCT/FI2000/001131**

(87) International publication number:
**WO 2001/047104 (28.06.2001 Gazette 2001/26)**

(54) **EMITTER FOLLOWER WITH CONSTANT COLLECTOR CURRENT BIASING MEANS**

EMITTENFOLGER MIT MITTELN ZUR POLARISIERUNG AUF EINEN KONSTANTEN
KOLLEKTORSTROM

EMETTEUR SUIVEUR AVEC DISPOSITIF DE POLARISATION A COURANT COLLECTEUR
CONSTANT

(84) Designated Contracting States:
**AT BE CH CY DE DK ES FI FR GB GR IE IT LI LU
MC NL PT SE TR**

(30) Priority: **22.12.1999 FI 992766**

(43) Date of publication of application:
**27.11.2002 Bulletin 2002/48**

(73) Proprietor: **Micro Analog Systems OY
02770 Espoo (FI)**

(72) Inventor: **SILLANPÄÄ, Tero
00800 - Helsinki (FI)**

(74) Representative: **Äkräs, Tapio Juhani
Oy Kolster Ab,
Iso Roobertinkatu 23,
P.O. Box 148
00121 Helsinki (FI)**

(56) References cited:
**DE-A1- 19 616 443          US-A- 4 751 404
US-A- 4 847 566          US-A- 4 870 533
US-A- 5 281 873**

Note: Within nine months from the publication of the mention of the grant of the European patent, any person may give
notice to the European Patent Office of opposition to the European patent granted. Notice of opposition shall be filed in
a written reasoned statement. It shall not be deemed to have been filed until the opposition fee has been paid. (Art.
99(1) European Patent Convention).

**Description**

**SUBJECT OF THE INVENTION**

The invention relates to frequency stabilization in emitter follower connections.

BACKGROUND OF THE INVENTION

An emitter follower is used as a buffer circuit and DC-level shifter of a signal. Its input impedance is high, whereby a large part of the signal power is transmitted from the stage preceding the emitter follower to the emitter follower, and its output impedance is low, whereby a large part of the signal power is transmitted from the emitter follower to the stage following the emitter follower. The emitter follower can be used in a wide frequency range, because its non-dominating pole is at high frequencies and generally remains above the operating frequency range of a device. In addition, the emitter follower is simple in structure.

In emitter follower structures, the input signal is fed to the base of a bipolar transistor (NPN, PNP) and the output signal is received from the emitter of the bipolar transistor. The transistor of the emitter follower is biased by a power source, for instance by a second bipolar transistor. When using an emitter follower connection of the PNP transistor, the difference V(VDD-OUT) between the operating voltage VDD of the circuit and the voltage in the output node OUT is smaller than when using an emitter follower connection of the NPN transistor. This is due to the fact that there is no voltage drop over the transistor. This property of the PNP emitter follower structure can be used in certain applications.

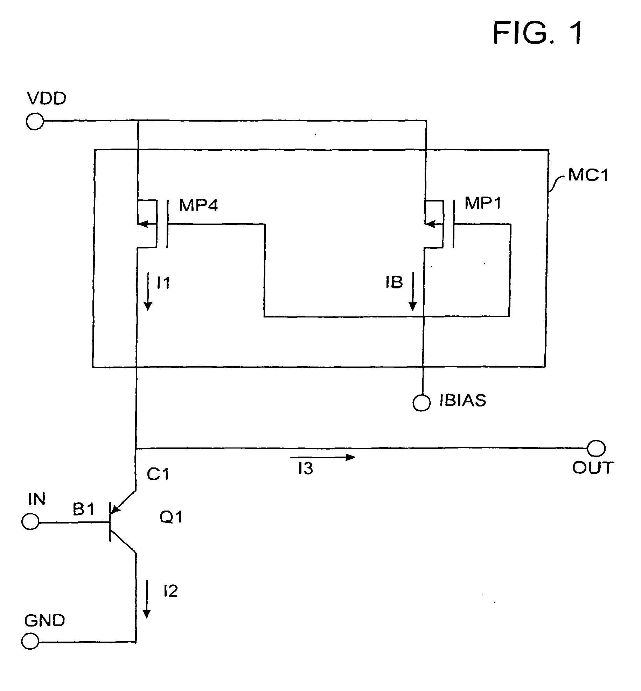

Figure 1 shows a prior art PNP emitter follower structure. The input signal to the emitter follower is fed to the base B1 to the PNP transistor Q1 and the output signal is received from the emitter E1 of the PNP transistor in question. The current I2 required for biasing the PNP transistor B1 is obtained by mirroring a current IB in a current mirror MC1 formed by transistors MP1 and MP4. The current mirror ratio of the current mirror MC1 is formed by the relation between the channel widths and lengths of the transistors MP4 and MP1.

A current 11 mirrored by the current mirror MC1 divides, however, into two parts, namely a load current I3 going out from the emitter follower and fed into the load and the current 12 needed for biasing the transistor Q1. Because the load current 13 can vary a great deal, the bias current 11 must be made so that it can in every situation feed into the load the current 13 required by the load. This can be mathematically expressed according to formula 1, wherein 13 (max) is the maximum value of the load current and the current 12 is the current needed for biasing the transistor B1.

$$I1 >= I3(max) + I2 \qquad\qquad (1)$$

When the load current varies a great deal, the collector current 12 of the transistor Q1 does it, too, and consequently, the location of the parasitic pole of the transistor Q1 changes in the frequency domain. Therefore, the current 11 must also be so high that the parasitic pole created by the current 12 is at a sufficiently high frequency even at the highest load current to ensure a broadband operation of the emitter follower. These magnitude requirements of the currents 12 and 13 result in a high current and power consumption of the emitter follower.

BRIEF DESCRIPTION OF THE INVENTION

It is an object of the present invention to provide the current required for biasing the emitter follower, whose magnitude does not change when the load current changes. The object of the invention is achieved by a method characterized by what is stated in the independent claims. Preferred embodiments of the invention are set forth in the dependent claims.

In an emitter follower circuit, the load is connected to an emitter of a PNP bipolar transistor. A current is fed through a biasing means to the emitter and divided in the emitter into a load current and a current running through the transistor. The collector current passed through the transistor generates a parasitic pole in the frequency domain. According to the invention, a control loop is generated, which controls a first current running through the biasing means in such a manner that the collector current of the transistor remains substantially constant regardless of variation in the load current. When this constant value is selected to set the corresponding parasitic pole outside a desired operation frequency range, the emitter follower or the electronic circuit in which it is used, is frequency-stable with all load current values.

In the first embodiment of the invention, the biasing means is a biasing transistor. The control loop is preferably provided by means of a current mirror structure or the like which turns a change in the collector current into a corresponding change in the control current or voltage of the biasing transistor in such a manner that the biasing transistor endeavours to maintain the collector current at a constant value.

Owing to the invention, current consumption is reduced, because a high excess current does not pass through the transistor at low load currents, as happens in the prior art emitter follower.

**BRIEF DESCRIPTION OF THE FIGURES**

In the following, the invention will be described in greater detail by means of the preferred embodiments and with reference to the appended drawings, in which

Figure 1 shows a prior art PNP emitter follower structure,

Figure 2 shows a PNP emitter follower structure of the invention.

DETAILED DESCRIPTION OF THE INVENTION

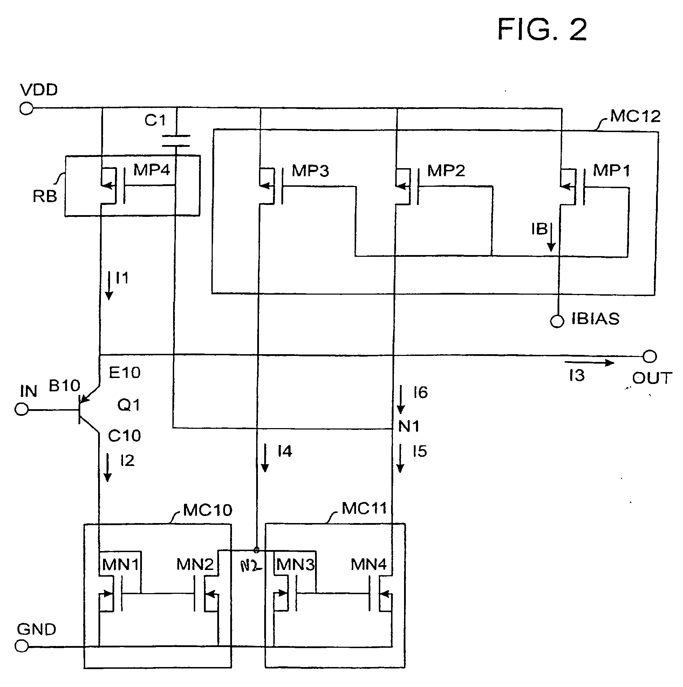

Figure 2 shows a PNP emitter follower structure of the invention, in which a control loop of the current, i.e. transistors MN1 to MN4, controls a current 11 in such a manner that a current 12 remains substantially constant regardless of the magnitude of a load current 13. The first preferred embodiment of the invention is shown as an integrated circuit, but it will be understood that the invention is not limited to this. For instance, constant currents and biasings can be implemented by constant current generators and other circuit solutions obvious to a person skilled in the art, even though current mirrors are used in Figure 2.

Currents I4 and I6 shown in Figure 2 are constant currents which are generated by a current mirror MC12. MC12 comprises PMOS transistors MP1, MP2 and MP3 whose source poles are connected to an operating voltage VDD. A bias current IB runs through the transistor MP1 to a biasing power source IBIAS which is connected to the drain of the transistor MP1. The gate of the transistor MP1 is connected to the gates of the transistors MP2 and MP3 and to the drain of the transistor MP1. The drain of the transistor MP2 is connected to a node N1 and through it to a current mirror MC11. The drain of the transistor MP3 is connected to a current mirror MC10. MP2 and MP3 mirror from the current IB constant currents 16 and 14 respectively, which are fed from the transistor drains to the current mirrors MC11 and MC10. According to the current mirroring ratio, they obtain values according to formulas 2 and 3.

$$I4 = (SMP3 / SMP1) * IB \qquad\qquad (2)$$

$$I6 = (SMP2 / SMP1) * IB \qquad\qquad (3)$$

wherein IB is a constant current and SMPz depicts the relation between the channel width and length of a transistor z according to formula 4.

$$SMPz = WMPz / LMPz \qquad\qquad (4)$$

The biasing of the PNP transistor Q1 is implemented by a PMOS transistor MP4 whose source pole is connected to the operating current VDD and whose drain is connected to an emitter E10 of the transistor Q1. The gate of the transistor MP4 is connected to the node N1. Additional capacitance is also provided to the drain by a capacitor C1 which is connected between the drain and the operating voltage VDD (source pole). In principle, the biasing can be implemented by any controllable power source, for instance by controlling the size of an impedance RB.

The current mirror MC10 comprises NMOS transistors MN1 and MN2. The drain of the transistor MN1 is connected to a collector C10 of the transistor Q1 and the source to a ground potential GND. The gate of the transistor MN1 is connected to the drain of the transistor MN1 and to the gate of the transistor MN2. The drain of the transistor MN2 is connected to the drain of the transistor MP3 in the current mirror MC12.

The current mirror MC11 comprises NMOS transistors MN3 and MN4. The drain of the transistor MN3 is connected to the drain of the transistor MP3 in the current mirror MC12 (i.e. to the drain of the transistor MN2) and the source is connected to the ground potential GND. The gate of the transistor MN3 is connected to the drain of the transistor MN3 and to the gate of the transistor MN4. The drain of the transistor MN4 is connected to the node N1 and the source is connected to the ground potential GND.

In Figure 2, a control loop is formed, in which the current mirrors MC10 and MC11 change the current 15 in inverse proportion to the change in the current 12 running through the transistor Q1. which for its part changes the gate voltage of the biasing transistor MP4 in such a manner that MP4 changes the current 11 toward the direction which returns the current 12 to its set value. In other words, the control loop tries to keep the current 12 constant and independent of the load current.

In the following, the operation of the control loop is examined in greater detail. In Figure 2, only the node N1 is a high-impedance node. All other nodes have a low impedance.

If the absolute value of the DC voltage amplification of the control loop in Figure 2 is considerably higher than one, the current I5 is substantially set to the same value as the constant current 16. The current 15 running through the drain of the transistor MN4 of the current mirror structure MC11 is the drain current of the second transistor MN3 of the same current mirror structure MC11 multiplied by the current mirroring ratio SMN43 of the current mirror structure in question.

$$I5 = IdMN4 = SMN43 * IdMN3 \qquad (5)$$

Because the current IdMN3 is obtained by subtracting from the constant current I4 the current IdMN2 running through the drain of the transistor MN2 of the current mirror structure MC10, and because the current IdMN2 is obtained by mirroring the current 12 in the current mirror structure MC10 by the current mirror ratio SMN21, the following formula 6 can be derived for the current 15.

$$I5 = SMN43 * I4 - SMN43 * SMN21 * I2 \qquad (6)$$

wherein SMNzx depicts the relation of the channel width and length of the transistor z to the relation of the channel width and length of the transistor x.

The operation of the circuit of the invention can be examined as follows. Let us assume that in situation A, the bias current 12 of the transistor Q1 increases. According to the formula 6, the current 15 then decreases. As a result of this, the voltage in the node N1 increases and the gate-source voltage of the transistor MP4 of the biasing power source RB decreases, thus decreasing the current I1 running through the transistor MP4. The decrease in the current I1 decreases the current I2, if it is assumed that the current 13 is substantially constant. In other words, if the current I3 is substantially constant, the control loop of the bias current of the transistor Q1, i.e. the transistors MN1 to MN4. decrease the current 12 when the current 12 tries to increase.

In a balanced condition, the current 15 is substantially equal to the current 16 and the formula 7 can be derived for the current 12.

$$I2 = (SM43 * I4 - I6) / (SMN21 * SMN21) \qquad (7)$$

The current I2 is thus set using the constant currents I4 and I6 and the current mirroring ratios of the current mirrors.

Let us assume next that in situation B, the current I3 is not constant, but increases. If the current I1 did not change, the current I2 would decrease. However, because the above-mentioned control loop controls the current 11 in such a manner that the current 12 tries to become a constant current, the change in the current I3 changes the current I1 in the same proportion. This way, the circuit of Figure 2 endures big changes of the load current I3 without a high bias current I1 being required. The current I1 is thus adapted in such a manner that the emitter follower of the invention can supply the current I2 + I3 in such a manner that the parasitic pole of the circuit remains at a high enough frequency.

The higher the amplification of the control loop MP1 to MP4, the more exactly is the current I2 constant. To make the current I5 to adjust to substantially the same value as the constant current 16, the absolute value of the DC voltage amplification of the control loop MP1 to MP4 must be considerably higher than one. The formula 8 of the absolute value ADC of the DC voltage amplification can be derived by disconnecting the gate of the transistor MP4 of the biasing impedance RB from the node N1 and by supplying a test voltage to the gate in question.

$$ADC = SMN43 * SMN21 * (gmMP4) / (gdMN4 + gdMP2) \qquad (8)$$

wherein gmMP4 depicts the transconductance of a small-signal model of the transistor MP4 and correspondingly, gdMN4 and gdMP2 depict the admittances of the transistors MN4 and MP4.

The capacitive component C1 in Figure 2 moves the dominating pole to a lower frequency and thus makes the circuit more stable than if the circuit operated without the capacitive component in question. The capacitive component is brought in to the circuit by connecting one of its poles to the node N1. The second pole of the capacitive component can, for instance, be connected to the outlet node OUT of the circuit or to the ground potential GND of the circuit.

The drawing and the related description are only intended to illustrate the invention. The invention may vary in detail within the scope of the appended claims.

**Claims**

1. An emitter follower circuit comprising a PNP bipolar transistor (Q1) whose emitter (E10) is connected to load and through a biasing means (RB) to a first operating voltage potential (VDD) and whose collector (C10) is connected to a second operating voltage potential (GND), **characterized by** a control loop which controls a first current (11) running through the biasing means in such a manner that a collector current (12) of the transistor remains, regardless of variation of a load current (13), substantially at a constant value whose corresponding parasitic pole in the frequency response of the emitter follower is at the desired frequency
the control loop comprising

   - a node (N1) to which a control electrode of the biasing means (RB) is connected,
   - first means (MC10, MC11) which generate a second current (15) in reverse proportion to the collector current (12), which second current runs from said node (N1) to said second operating voltage potential (GND),
   - second means (MC12) which supply a constant current (16) to said node (N1), and the control loop is in balance and the collector current (12) at its constant value when said second current (15) and said constant current (16) are equal.

2. An emitter follower circuit as claimed in claim 1, **characterized in that** the control loop controls the first current (11) running through the biasing means (RB) in the opposite direction to the change of the collector current (12) so that the collector current returns to its constant value.

3. An emitter follower circuit as claimed in claim 1 or 2, **characterized in that** the biasing means (RB) comprises a biasing transistor (MP4) and that the control loop controls the operating current of the biasing transistor so that the collector current (12) remains substantially at a constant value.

4. An emitter follower circuit as claimed in claim 1, wherein

   - said second means comprise a current generator (MP3) which provides a second constant current (14) to a second node; and a second current generator (MP2) which produces said constant current (16) to said first node (N1), and
   - said first means comprise a first current mirror (MC10) which produces a third current in direct proportion to the collector current (I2), the third current running from said second node; and a second current mirror (MC11) which is connected to said second node to produce said second current (I5), said second current (I5) running from said first node (N1) to the second operating voltage (GND) and being proportional to the difference between said second constant current (I4) and said third current.

5. An emitter follower circuit as claimed in claims 1, 3 or 4, **characterized in that** an additional capacitance (C1) is connected to the control electrode of the biasing means (RB) to improve the frequency stability.

**Patentansprüche**

1. Emittierfolgerschaltung mit einem bipolaren PNP-Transistor (Q1), dessen Emitter (E10) mit einer Last und durch eine Vorspannungseinrichtung (RB) mit einem ersten Betriebsspannungspotential (VDD) verbunden ist, und dessen Kollektor (C10) mit einem zweiten Betriebsspannungspotential (GND) verbunden ist, **gekennzeichnet durch** eine Steuerschleife, die einen ersten **durch** die Vorspannungseinrichtung fließenden Strom (11) derart steuert, dass ein Kollektorstrom (12) des Transistors, ohne Rücksicht auf eine Veränderung eines Laststroms (13), im Wesentlichen auf einem konstanten Wert bleibt, deren entsprechender parasitärer Pol in dem Frequenzgang des Emitterfolgers bei der gewünschten Frequenz ist, wobei die Steuerschleife umfasst:

   einen Knoten (N1), mit dem eine Steuerelektrode der Vorspannungseinrichtung (RB) verbunden ist,
   erste Einrichtungen (MC10, MC11), die einen zweiten Strom (I5) in umgekehrtem Verhältnis zu dem Kollektorstrom (12) erzeugen, wobei der zweite Strom von dem Knoten (N1) zu dem zweiten Betriebsspannungspotential (GND) fließt, und
   zweite Einrichtungen (MC12), die einen konstanten Strom (I6) zu dem Knoten (N1) liefern, und die Steuerschleife ausgeglichen und der Kollektorstrom (I2) auf seinem konstanten Wert ist, wenn der zweite Strom (I5) und der konstante Strom (16) gleich sind.

2. Emitterfolgerschaltung gemäß Anspruch 1, **dadurch gekennzeichnet, dass** die Steuerschleife den ersten Strom (I1) steuert, der durch die Vorspannungseinrichtung (RB) in der entgegengesetzten Richtung zu der Änderung des Kollektorstroms (12) fließt, sodass der Kollektorstrom zu seinem konstanten Wert zurückkehrt.

3. Emitterfolgerschaltung gemäß Anspruch 1 oder 2, **dadurch gekennzeichnet, dass** die Vorspannungseinrichtung (RB) einen Vorspannungstransistor (MP4) umfasst und dass die Steuerschleife den Betriebsstrom des Vorspannungstransistors steuert, sodass der Kollektorstrom (I2) im Wesentlichen auf einem konstanten Wert bleibt.

4. Emitterfolgerschaltung gemäß Anspruch 1, wobei
   die zweiten Einrichtungen einen Stromgenerator (MP3), der einen zweiten konstanten Strom (14) zu einem zweiten Knoten liefert, und einen zweiten Stromgenerator (MP2), der den konstanten Strom (I6) zu dem ersten Knoten (N1) erzeugt, umfassen, und
   die ersten Einrichtungen umfassen: einen ersten Stromspiegel (MC10), der einen dritten Strom in direktem Verhältnis zu dem Kollektorstrom (I2) erzeugt, wobei der dritte Strom von dem zweiten Knoten fließt, und einen zweiten Stromspiegel (MC11), der mit dem zweiten Knoten verbunden ist, um den zweiten Strom (15) zu erzeugen, wobei der zweite Strom (I5) von dem ersten Knoten (N1) zu der zweiten Betriebsspannung (GND) fließt und proportional der Differenz zwischen dem zweiten konstanten Strom (14) und dem dritten Strom ist.

5. Emitterfolgerschaltung gemäß Anspruch 1, 3 oder 4, **dadurch gekennzeichnet, dass** eine zusätzliche Kapazität (C1) mit der Steuerelektrode der Vorspannungseinrichtung (RB) verbunden ist, um die Frequenzstabilität zu verbessern.

**Revendications**

1. Circuit émetteur-suiveur comportant un transistor bipolaire PNP (Q1) dont l'émetteur (E10) est connecté à une charge et à travers des moyens de polarisation (RB) à un premier potentiel de tension de fonctionnement (VDD) et dont le collecteur (C10) est connecté à un second potentiel de tension de fonctionnement (GND), **caractérisé par** une boucle de commande qui commande un premier courant (I1) se déplaçant à travers les moyens de polarisation de telle sorte qu'un courant de collecteur (I2) du transistor reste, quelle que soit la variation d'un courant de charge (I3), essentiellement à une valeur constante dont le pôle parasite correspondant dans la réponse fréquentielle de l'émetteur-suiveur est à la fréquence voulue
   la boucle de commande comportant

   - un noeud (N1) auquel une électrode de commande des moyens de polarisation (RB) est connectée,
   - des premiers moyens (MC10, MC11) qui génèrent un deuxième courant (I5) proportionnellement inverse au courant de collecteur (I2), lequel deuxième courant se déplace depuis ledit noeud (N1) vers ledit second potentiel de tension de fonctionnement (GND),
   - des seconds moyens (MC12) qui alimentent un courant constant (I6) dans ledit noeud (N1), et la boucle de commande est en équilibre et le courant de collecteur (I2) à sa valeur constante lorsque ledit deuxième courant (I5) et ledit courant constant (I6) sont égaux.

2. Circuit émetteur-suiveur selon la revendication 1, **caractérisé en ce que** la boucle de commande commande le premier courant (I1) se déplaçant à travers les moyens de polarisation (RB) dans la direction opposée au changement du courant de collecteur (I2) de sorte que le courant de collecteur revient à sa valeur constante.

3. Circuit émetteur-suiveur selon la revendication 1 ou 2, **caractérisé en ce que** les moyens de polarisation (RB) comporte un transistor de polarisation (MP4) et **en ce que** la boucle de commande commande le courant de fonctionnement du transistor de polarisation de sorte que le courant de collecteur (I2) reste essentiellement à une valeur constante.

4. Circuit émetteur-suiveur selon la revendication 1, dans lequel

- lesdits seconds moyens comportent un générateur de courant (MP3) qui délivre un second courant constant (I4) dans un second noeud, et un second générateur de courant (MP2) qui produit ledit courant constant (I6) dans ledit premier noeud (N1), et
- lesdits premiers moyens comportent un premier miroir de courant (MC10) qui produit un troisième courant proportionnellement direct au courant de collecteur (I2), le troisième courant se déplaçant depuis le second noeud ; et un second miroir de courant (MC11) qui est connecté audit second noeud pour produire ledit deuxième courant (I5), ledit deuxième courant (I5) se déplaçant depuis ledit premier noeud (N1) vers la seconde tension de fonctionnement (GND) et étant proportionnel à la différence entre ledit second courant constant (I4) et ledit troisième courant.

5. Circuit émetteur-suiveur selon les revendications 1, 3 ou 4, **caractérisé en ce qu'**un condenseur supplémentaire (C1) est connecté à l'électrode de commande des moyens de polarisation (RB) pour améliorer la stabilité de fréquence.

# FIG. 1

VDD

MP4    MC1

I1    MP1

IB

IBIAS

C1    I3    OUT

IN
B1    Q1

I2

GND

FIG. 2